# EUROPÄISCHE PATENTANMELDUNG

(11) **EP 1 865 331 A2**
(43) Veröffentlichungstag der Anmeldung: **12.12.2007**
(21) Anmeldenummer: 07004986.1
(22) Anmeldetag: 10.03.2007
(51) Int. Cl.: G01R 15/20, G01R 19/00

(54) **Elektrisches/elektronisches Gerät**

(30) Priorität: 06.06.2006 DE 102006026148
(71) Anmelder: INSTA ELEKTRO GmbH, 58511 Lüdenscheid (DE)
(72) Erfinder: Rauterkus, Frank, Dipl.-Ing., 57439 Attendorn (DE); Grochowski, Torsten, 58507 Lüdenscheid (DE)

(57) **Zusammenfassung**

Es wird ein elektrisches/elektronisches Gerät, insbesondere ein Aktor für ein Bussystem der Gebäudesystemtechnik mit zumindest einem Laststrompfad vorgeschlagen, welchem zur Strommessung zumindest ein Hallsensor (6) zugeordnet ist. Zu dem Zweck, ein elektrisches/elektronisches Gerät zu schaffen, bei dem auf einfache Art und Weise eine Trennung mit entsprechender Isolation zwischen der Laststromseite und Busseite realisiert ist und die den Hallsensoren zugeordneten Mess- und Auswerteschaltungen auf besonders einfache Art und Weise mit der notwendigen Energie zu versorgen sind, ist der Laststrompfad im Bereich des Hallsensors als zumindest eine, von zumindest einer Isolationsschicht (5a,5b,5c) abgedeckten Leiterbahn (2a,2b) einer Leiterplatte (1) ausgeführt, und ist der Hallsensor unter Zwischenschaltung einer Isolationsschicht zumindest einer Leiterbahn zugeordnet.

## Beschreibung

Die vorliegende Erfindung geht von einem gemäß Oberbegriff des Hauptanspruches konzipierten elektrischen/elektronischen Gerät aus.

Derartige elektrische/elektronische Geräte sind in der Regel dafür vorgesehen, eine Vielzahl von in Gebäuden installierte, an ein Bussystem angeschlossene weitere elektrische Geräte (Jalousieantriebe, Beleuchtungseinrichtungen, Haushaltsgeräte, Warnanlagen, usw.) bedarfsgerecht zu beeinflussen, bzw. zu überwachen. Zu diesem Zweck sind die unterschiedlichsten elektrischen/elektronischen Geräte bekannt geworden. Oftmals sind weitere elektrische Geräte so im Gebäude angebracht bzw. angeordnet, so dass deren Funktion bzw. Funktionszustand vom Benutzer nicht direkt ausgemacht werden kann. Beispielsweise ist eine Beleuchtungsanlage im Außenbereich oder in einem langen Flurbereich angebracht, wobei die Leuchtmittel vom Benutzer nicht direkt gesehen werden können oder eine Waschmaschine ist im Keller des Gebäudes aufgestellt, so dass der Funktionszustand der Waschmaschine für den Benutzer nicht erkennbar ist. Für den Benutzer ist es bei solchen Installationen deshalb oftmals wichtig zu erkennen, ob z. B. Leuchtmittel der Beleuchtungsanlage defekt sind bzw. die Waschmaschine mit ihrem Waschvorgang fertig ist. Aus diesem Gunde sind Geräte bekannt geworden, bei welchen unter Zuhilfenahme von Hallsensoren der Laststrom gemessen wird. D. h. mit Hilfe solcher Hallsensoren können zu Kontroll-, Mess-, Überwachungs- oder Meldezwecken zusätzliche Informationen, wie z. B. Leuchtmitteldefekt, Sicherung ausgefallen, Waschvorgang beendet, Schaltzustand Ein bzw. Aus in das Bussystem abgegeben und an zentraler Stelle zur Anzeige gebracht werden.

Durch die DE 102 53 018 A1 ist ein dem Oberbegriff des Hauptanspruches entsprechendes elektrisches/elektronisches Gerät bekannt geworden, bei welchem zumindest einem Laststrompfad zum Zwecke der Strommessung zumindest ein Hallsensor zugeordnet ist. Der Lasttrompfad dieses Schaltgerätes weist jedoch keine besonderen Isolationsmaßnahmen auf, so dass bei einer Anwendung in einem Bussystem ein erheblicher Aufwand getrieben werden muss, um die vorgeschriebene Isolation (Kriechstrecke) zwischen der Laststromseite und der Busseite einzuhalten. Außerdem ist ein erhöhter Aufwand notwendig, um die dem Hallsensor zugeordnete Mess- und Auswerteschaltung mit ausreichender Energie versorgen zu können.

Ausgehend von einem derart ausgebildeten elektrischen/elektronischen Gerät liegt der vorliegenden Erfindung die Aufgabe zugrunde, ein Gerät zu schaffen, bei dem auf einfache Art und Weise eine Trennung mit entsprechender Isolation (Kriechstrecke) zwischen der Laststromseite und der Busseite realisiert ist und die den Hallsensoren zugeordneten Mess- und Auswerteschaltungen auf besonders einfache Art und Weise mit der notwendigen Energie zu versorgen sind.

Erfindungsgemäß wird diese Aufgabe durch die im Hauptanspruch angegebenen Merkmale gelöst.

Bei einer solchen Ausbildung ist besonders vorteilhaft, dass eine 4 kV Trennung zwischen dem zu messenden Laststrom und der Mess- und Auswerteschaltung der Busseite auf besonders einfache Art und Weise realisiert ist. Die Fertigung solcher Geräte ist einfach und kostengünstig, weil nur ein sehr geringer Anteil an Handarbeit anfällt. Zudem ist besonders vorteilhaft, dass bei einer derartigen Strommessung keine größeren Gehäuse oder zusätzlichen Leiterplatten bei identischer Anzahl zu überwachender Kanäle notwendig werden. Zudem können einfach durch Minderbestückungen Varianten ohne Strommessung hergestellt werden.

Weitere vorteilhafte Ausgestaltungen des erfindungsgemäßen Gegenstandes sind in den Unteransprüchen angegeben. Anhand eines Ausführungsbeispiels sei die Erfindung im Prinzip näher erläutert. Dabei zeigt:
- Figur 1:: einen Schnitt durch ein prinziphaft dargestelltes elektrisches/elektronisches Gerät;
- Figur 2:: prinziphaft eine Unteransicht der Leiterplatte des elektrischen/elektronischen Gerät;
- Figur 3:: prinziphaft die den Hallsensor und den Laststrompfad umgebende Schirmung.

Wie aus den Figuren hervorgeht, weist ein solches, als mehrkanaliger Schaltaktor ausgeführtes elektrisches/elektronisches Gerät eine Leiterplatte 1 auf, in die je Kanal ein Laststrompfad integriert ist. Jeder Laststrompfad besteht aus zwei übereinander liegend angeordneten Leiterbahnen 2a, 2b die zum Zwecke ihrer Isolation in das Leiterplattenmaterial der Leiterplatte 1 integriert sind. Einerseits steht jeder Laststrompfad mit einer auf der Leiterplatte 1 festgelegten Lastklemme 3a, 3b und andererseits mit dem Schaltkontakt eines auf der Leiterplatte 1 angeordneten Relais 4 in Verbindung. Dadurch das die beiden Leiterbahnen 2a, 2b je Laststrompfad in die Leiterplatte 1 integriert sind, ergeben sich drei Isolationsschichten 5a, 5b, 5c, welche die Leiterbahnen 2a, 2b quasi vollständig aufnehmen. Jedem Laststrompfad ist ein Hallsensor 6 zur Strommessung zugeordnet. Von den drei Isolationsschichten 5a, 5b, 5c trägt im Wesentlichen die obere Isolationsschicht 5a zur Realisierung der notwendigen Kriechstrecke K bei, um die vorgeschriebene Trennung zwischen der Laststromseite und der mit Kleinspannung betriebenen Busseite des elektrischen/elektronischen Gerätes sicherzustellen. Mit den vorsehend beschriebenen Maßnahmen wird auf einfache Art und Weise eine 4 kV Trennung zwischen der Laststromseite und der Busseite erreicht.

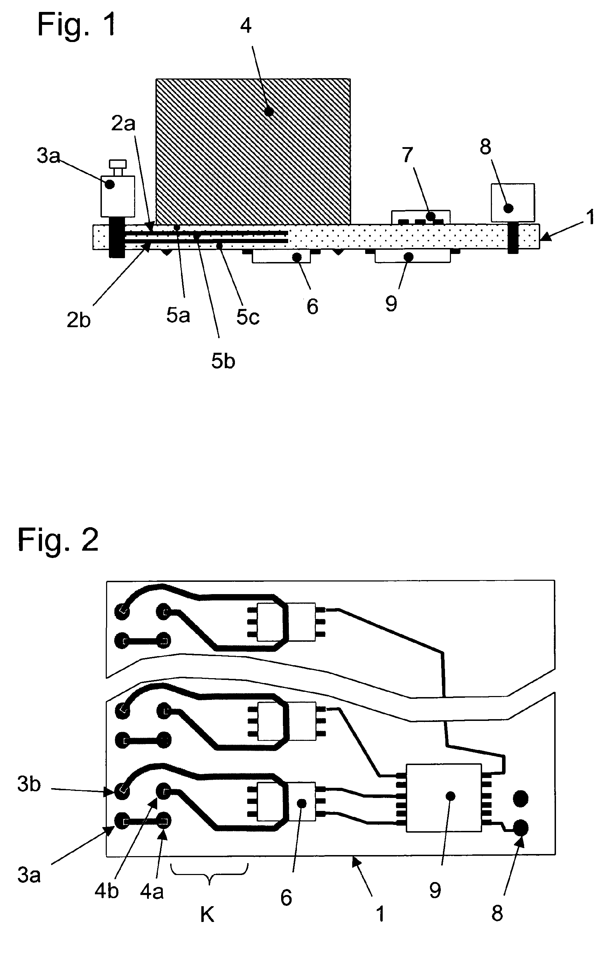

Wie des weiteren insbesondere aus Figur 1 hervorgeht, steht das Relais 4 mit seiner Ansteuerseite über einen, zu einem, der Einfachheit halber nicht näher dargestellten Busankoppler gehörigen Mikrocontroller 7 mit einem auf der Leiterplatte 1 angeordneten Busanschluss 8 in Verbindung. Außerdem steht auch der Hallsensor 6 über eine Messauswertung 9 und den Mikrocontroller 7 des Busankopplers mit dem Busanschluss 8 in Verbindung.

Wie insbesondere aus Figur 2 hervorgeht, fließt der Laststrom von der Lastklemme 3a über die Anschlüsse 4a, 4b des -der Einfachheit halber nicht näher dargestellten-Schaltkontaktes des Relais 4. Vom Anschluss 4a aus wird der Laststrom zur Messung unter dem Hallsensor 6 hergeleitet und fließt danach zur Lastklemme 3b.

Die beiden Leiterbahnen 2a, 2b sind wie bereits beschrieben in das Leiterplattenmaterial integriert bzw. auf den Innenlagen der Leiterplatte 1 angeordnet. Die Leiterplatte 1 besteht aus Epoxidharz-Glashartgewebe-Laminat FR4, wodurch bei einfacher Integration der Leiterbahnen 2a, 2b eine hohe Isolationswirkung gewährleistet ist.

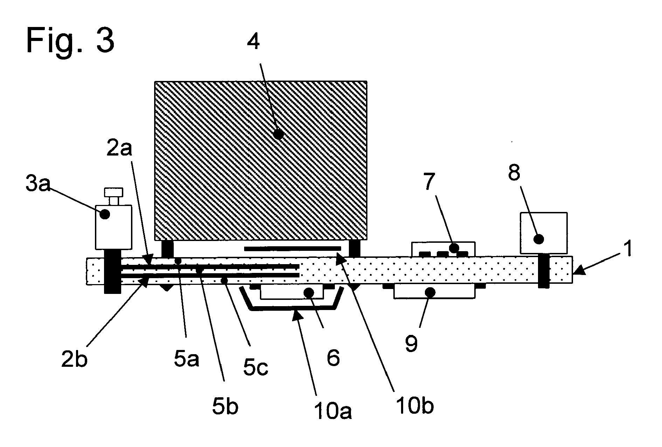

Wie insbesondere aus Figur 3 hervorgeht, ist dem Hallsensor 6 und in dessen Bereich den beiden Leiterbahnen 2a, 2b des Laststrompfades 2 eine Schirmung 10a, 10b zugeordnet, welche bewirkt, dass Strömungen durch Magnetfelder reduziert werden, die nicht durch den Laststrom hervorgerufen werden, der dem Hallsensor 6 zugeordnet ist. Insbesondere können Wechselfelder von Leitungen unter dem Gerät oder von Transformatoren neben dem Gerät teilweise abgeblockt werden.

## Patentansprüche

1. Elektrisches/elektronisches Gerät, insbesondere Aktor für ein Bussystem der Gebäudesystemtechnik mit zumindest einem Laststrompfad, welchem zur Strommessung zumindest ein Hallsensor zugeordnet ist, **dadurch gekennzeichnet, dass** der Laststrompfad im Bereich des Hallsensors (6) als zumindest eine, von zumindest einer Isolationsschicht (5a, 5b, 5c) abgedeckten Leiterbahn (2a, 2b) einer Leiterplatte (1) ausgeführt ist, und dass der Hallsensor (6) unter Zwischenschaltung einer Isolationsschicht (5a, 5b, 5c) zumindest einer Leiterbahn (2a, 2b) zugeordnet ist.

2. Elektrisches/elektronisches Gerät nach Anspruch 1, **dadurch gekennzeichnet, dass** zumindest eine Isolationsschicht (5a, 5b, 5c) zumindest eine Leiterbahn (2a, 2b) überdeckend auf die Leiterplatte (1) aufgebracht ist.

3. Elektrisches/elektronisches Gerät nach Anspruch 1 oder 2, **dadurch gekennzeichnet, dass** zumindest eine Isolationsschicht (5a, 5b, 5c) durch Integration zumindest einer Leiterbahn (2a, 2b) in das Leiterplattenmaterial realisiert ist, also zumindest eine Leiterbahn (2a, 2b) in die Leiterplatte (1) integriert ist.

4. Elektrisches/elektronisches Gerät nach einem der Ansprüche 1 bis 3, **dadurch gekennzeichnet, dass** zumindest ein Laststrompfad aus zumindest zwei in und/oder auf der Leiterplatte (1) vorhandenen Leiterbahnen (2a, 2b) besteht.

5. Elektrisches/elektronisches Gerät nach einem der Ansprüche 1 bis 4, **dadurch gekennzeichnet, dass** zumindest ein Laststrompfad einerseits mit einer auf der Leiterplatte (1) befestigten Lastklemme (3a, 3b) und andererseits mit dem Schaltkontakt eines Relais (4) in Verbindung steht.

6. Elektrisches/elektronisches Gerät nach einem der Ansprüche 1 bis 5, **dadurch gekennzeichnet, dass** der Hallsensor (6) mit einem auf der Leiterplatte (1) befindlichen Busanschluss (8) in Verbindung steht.

7. Elektrisches/elektronisches Gerät nach einem der Ansprüche 1 bis 6, **dadurch gekennzeichnet, dass** die Leiterplatte (1) mit einem Epoxidharz-Glashartgewebe-Laminat (FR4) als Basismaterial ausgeführt ist.

8. Elektrisches/elektronisches Gerät nach einem der Ansprüche 1 bis 7, **dadurch gekennzeichnet, dass** das Gerät als mehrkanaliger Schaltaktor ausgeführt ist.

9. Elektrisches/elektronisches Gerät nach einem der Ansprüche 1 bis 8, **dadurch gekennzeichnet, dass** der Hallsensor (6) und zumindest der dem Hallsensor (6) zugeordnete Bereich des Laststrompfades mit einer Schirmung (10a, 10b) versehen sind.
